# EUROPEAN PATENT APPLICATION

(11) **EP 1 239 056 A1**
(43) Date of publication of application: **11.09.2002**
(21) Application number: 02425037.5
(22) Date of filing: 29.01.2002
(51) Int. Cl.: C23C 14/32, C23C 14/30

(54) **Improvement of a method and apparatus for thin film deposition, especially in reactive conditions**

(30) Priority: 06.02.2001 IT RM010060
(71) Applicant: Misiano, Carlo, 00161 Roma (IT); Pulker, Hans K., 9495 Triesen (LI)
(72) Inventor: Misiano, Carlo, 00161 Roma (IT); Pulker, Hans K., 9495 Triesen (LI)

(57) **Abstract**

Apparatus and method for thin film deposition especially in reactive conditions. The most important problem solved by the invention is the realisation of optical coatings with negligible optical absorption, of high quality and low cost even on unheated substrates, being the improvement due to the introduction of a further plasma at RF/pulsed DC, in comparison with the previous techniques, produced by the substrates holder RF/pulsed DC bias which generates a plasma in front of the substrates. The invention lies in the technical field of the thin film treatments and in the application field of the production of thin films, in particular for optical use. This further plasma allows to obtain the right staichiometry of the deposited film by increasing the reactivity of the reactive gas present in the plasma and, in addition, introduces an energetic ion bombardment of the substrate before and during the growth of the film which improves the adherence and the deposit compactness.

## Description

The invention relates an improvement in an apparatus and related method, for thin film deposition, especially in the reactive mode. It places in the thin films production field and is applicable in the field of vacuum plants for thin film deposition. With the respect to the state of art, it solves, in particular, the problem of the partial or residual optical absorption, in optical coatings, realised by a method and apparatus relating to a previous solution of which the pat. No. CH 928/85. This solution, Fig.1, which lies in the field of Ion Plating technologies, is based on the fact that the material vaporised by an electron beam gun is ionised, in high percentage, in a reactive environment, by means of a low energy electrons bombardment. The substrates to be treated are connected on a substrate holder floating, under the electric aspect, so that said substrates are polarised with a bias voltage between -5 and -60V. Under these conditions, the obtained optical coatings are partially absorbing. This is an inconvenience which heavily limits their applicability, often because of their optical losses, especially in multilayer structures, and for the impossibility to utilise these coatings when a high laser damage threshold is requested. This absorption is generated by energetic ion bombardment of the vaporised material and the other ions present in the process atmosphere. This kind of process has been made mainly for the deposition of oxide, nitride, oxinitride and carbide layers.

In the other side, the cited method, allowed, in respect of the other conventional techniques, to realise, high compactness films, even on substrates at low temperatures, so that the refractive index is near to the value of the bulk material and the layer shows high mechanical and environmental characteristics.

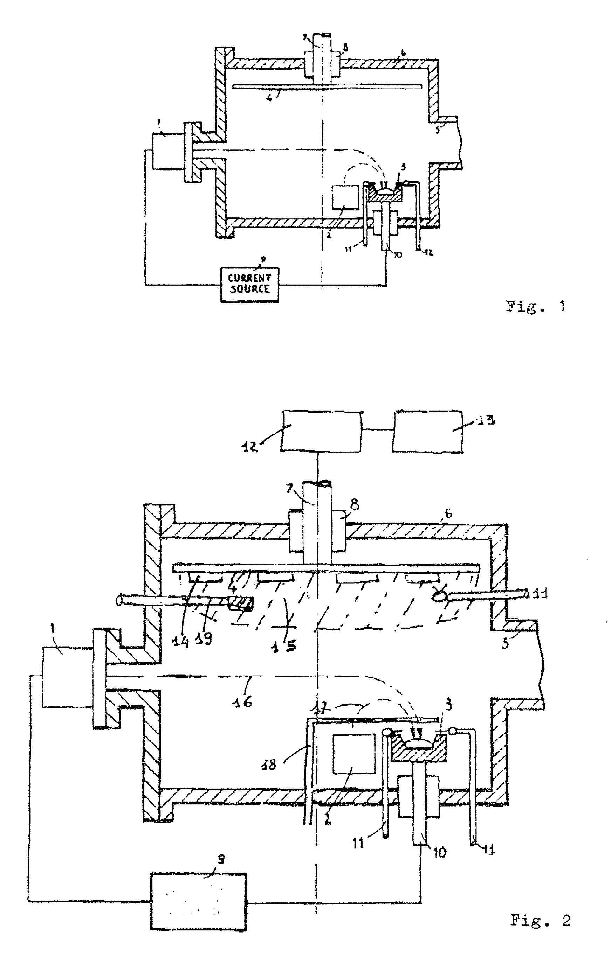

The proposed solution, for which a patent is requested, Fig. 2, in respect of the solution before described, is based on the generation in front of substrates, of a further plasma, RF or DC, also pulsed excited, by means of the substrate holders bias, which becomes cathodic structure, and the introduction of a gaseous mixture, generally composed with an inert gas, for instance Argon, and, in addition, a selected reactive gas, like Oxygen or Nitrogen, until reaching the desired pressure, as 10⁻³ / 10⁻² Torr.

This plasma, generated in front of substrates, creates an self-bias of the said substrates which can vary among some tents and many hundreds V.

The effects of this plasma are manifold. The most important are:
- **increase of discharge atmosphere reactivity** due to the ion bombardment of the substrates by reactive gas molecules, and to the ionisation and excitation of the same reactive gas; this reactivity increase compensates the possible dissociation caused by the energetic ion bombardment;
- **addition of energetic ion bombardment of the growing film** by plasma atmosphere ions producing a higher film compactness during the growth and an improvement of its adherence;
- **energy increase of the ionised condensing particles,** that, because of an increasing of duration of the "adatom" phase, causes a further increase of compactness and mechanical stability of the film, while the refractive index reaches values very near to the bulk material;
- **increase of the maximum deposition rate utilisable,** without any absorption, so that the process duration is dramatically reduced and the treatment cost too.

The apparatus, according to the proposed configuration, shows almost the total disappearance of the optical absorption and a strong increase of the refractive index in films realised, in respect of those obtained in accordance to the previous configuration, even using higher deposition rate.

### Figures list

Fig.1- Previous solution configuration.

Fig.2-Schematic representation of the deposition films apparatus in which:
- 1: Low energy electrons generator;
- 2: High energy electrons generator;
- 3: Crucible containing the material to be vaporised;
- 4: Biased substrate holders;
- 5: Pumping group connection;
- 6: Vacuum chamber;
- 7: Insulated feedthrough to bias the substrate holder;
- 8: insulators of the **feedthrough** 7;
- 9: power generator for low energy electrons;
- 10: insulated **feedthrough** for the crucible connection to the low energy electrons circuit;
- 11: process gases inlet;
- 12: matching network for RF generator;
- 13: RF generator;
- 14: Substrates;
- 15: Plasma generated by the bias of the substrate holder;
- 16: Low energy electron flux;
- 17: High energy electron flux;
- 18: Shutter of the vaporising source;
- 19: Film thickness and deposition rate monitor.

The method, the process and the apparatus in which said process is realisable, are described in the following, according to a version actually preferred by the inventors. Reference is made to the figures attached.

In the apparatus for of thin film deposition, Fig. 2, the substrates 14, after the necessary cleaning cycle, are positioned and fixed on the substrate holder 4. Said substrate holder is rotating to obtain a better thickness uniformity of the thin films on the substrates. Obviously, this substrate holder could be even standing.

The vacuum cycle of the chamber 6 begins through the gate 5 until a pressure of about 10⁻⁶ Torr. Keeping the mechanical shutter positioned in front of the source, to inhibit the optical view of the substrates, it is preheated by the electron beam at high energy, and, in the case, the material to vaporise is melted.

Now, in the chamber 6, is injected the gaseous mixture coming from the inlet 11, controlling by vacuum gauge and flow meters, the desired composition.

The RF source for the bias of the substrate holder 4 is activated. This generates a plasma 15 which produces an self bias of the substrate holder of some hundred Volts and generates a ion bombardment of the substrates, producing the final cleaning of the substrates. The shutter 18 is then open, and the low energy electrons source 1 is activated so that the electrons bombard the material, in the crucible 3, which can be rotating or multiple, in vaporisation phase, causing the ionization of an high percentage of the evaporating material. The presence of this material, strongly ionised, produces a dramatic decrease of self bias of the substrates of 50 percentage or more. In these conditions, controlling with the film thickness monitor and deposition rate monitor **19**, the deposition rate, the film is deposed until the desired thickness. In the case of a multilayer structure, the deposing process is repeated rotating the crucible 3 where the material is located, or utilising a second electron beam gun. When the depositions are completed, sources and generators are put off, gas inlet closed, the chamber is opened and the substrates are removed.

## Claims

1. Apparatus for thin film deposition, comprising a vacuum chamber (6), evacuated by appropriate pumping group, through the connection (5), **characterised by** the fact to be equipped with one or more vaporising sources like electron gun, with single or multiple rotating crucible (3), with a low energy electrons source (1), with the generator (9) and a cathodic substrate holder (4) also rotating, RF/pulsed DC biased by an insulated feedthrough (7) with appropriate generator (13) and matching network (12), gas or gaseous mixtures inlets (11); instrumentation (19) for measures and controls, one or more shutters (18).

2. Apparatus, as for Claim 1, in which said vaporisation source is a crucible electrically heated, or sputtering.

3. Apparatus for the thin film deposition, as for Claim 1, having a vaporisation source of material partially ionised by interactions with low energy electrons and a substrates holder RF or DC, also pulsed, biased, which generates a plasma in front of the substrates.

4. Process for thin film deposition, especially for optical applications, generally reactive, in which the vaporised material is partially ionised, even at high level, by means of interaction with low energy electrons; the substrates are placed on a biased cathode, generally at RF pulsed DC, and generally reactive, in from of the substrates and said plasma increases the reactivity of the gaseous mixture and generates an ionic bombardment of the substrates before and during the film deposition.

5. Process for thin film deposition, particularly for optical applications, generally reactive, **characterised by** the following procedure phases: in an apparatus, as for Claims 1 and 2, for thin films deposition, substrates (14), after the usual cleaning cycle, are positioned and fixed on the substrate holder (4); after the evacuation of the chamber (6), through the connection (5), until to reach a pressure of about 10⁻⁶ Torr; maintaining the shutter (18) positioned in front of the source, so that the substrates optical view could be inhibited, the material to be vaporised is preheated by the electron beam and, in the case, melted; then the gaseous mixture, coming from the inlet (11) is injected in the chamber (6), controlling by vacuum meters and flow meters, the pressure and composition desired; the RF/pulsed DC source is activated for the substrates holders (4) bias; this generates a plasma (15) which produces a self bias of substrates holder of about some hundreds Volts producing a ion bombardment of the substrates effecting their final cleaning; then the mechanical shutter (18) is open and activated the low energy source (1) of electrons which bombard the material, in the crucible (3), in the vaporisation phase, causing the high ionisation of the evaporating material; the presence of this material strongly ionised produces a dramatic decrease of self bias in the substrates holder, of the order of the 50 percentage; in these conditions, controlling by the monitor (19), the deposition rate, the film is deposited until the desired thickness; ended the depositions, the source and the power generators are put off, the gas inlet is closed; at this point the chamber is opened and the substrates are removed.

6. Process, as for Claim 5, that in the case of a multilayer structure, the deposition process can be repeated rotating the crucible (3) of the material, or utilising an other electron beam gun.
